# EUROPEAN PATENT APPLICATION

(11) **EP 2 814 071 A1**
(43) Date of publication of application: **17.12.2014**
(21) Application number: 12868299.4
(22) Date of filing: 04.07.2012
(51) Int. Cl.: H01L 33/50, C09K 11/08, C09K 11/62, C09K 11/80

(54) **LIGHT-EMITTING DEVICE**

(30) Priority: 08.02.2012 JP 2012024709
(71) Applicant: Panasonic Corporation, Kadoma-shi, Osaka 571-8501 (JP)
(72) Inventor: OKUYAMA, Kojiro, Osaka 540-6207 (JP); OHBAYASHI,Takashi, Osaka 540-6207 (JP); SHIRAISHI, Seigo, Osaka 540-6207 (JP)
(74) Representative: Eisenführ Speiser
(86) International application number: PCT/JP2012/004338
(87) International publication number: WO 2013/118200

(57) **Abstract**

Provided is a high-efficiency light-emitting device. Further, provided is a light-emitting device with high efficiency and less variation in the color temperature of emitted white light in the case of configuring, for example, a white light-emitting device combining a blue LED and a phosphor layer. The light-emitting device includes a phosphor layer that emits light having a predetermined wavelength, and the phosphor layer contains at least one selected from the group consisting of a phosphor represented by a general formula:

aYO_{3/2} • (3-a)CeO_{3/2} • bAlO_{3/2} • cGaO_{3/2} • fWO₃ (2.80 ≤ a ≤ 2.99, 3.00 ≤ b ≤ 5.00, 0 ≤ c ≤ 2.00,

0.003 ≤ f ≤ 0.020, where 4.00 ≤ b+c ≤ 5.00), and a phosphor represented by a general formula: aYO_{3/2} • (3-a)CeO_{3/2} • bAlO_{3/2} • cGaO_{3/2} • gK₂WO₄ (2.80 ≤ a ≤ 2.99, 3.00 ≤ b ≤ 5.00, 0 ≤ c ≤ 2.00, 0.003 ≤ g ≤ 0.015, where 4.00 ≤ b+c ≤ 5.00).

## Description

### Technical Field

The present invention relates to a light-emitting device that uses yttrium-aluminum-garnet-type phosphors.

### Background Art

Conventionally, a compound represented by a chemical formula Y₃Al₅O₁₂ has been known widely under the name of yttrium aluminum garnet and used in solid-state lasers, translucent ceramics, etc.

Particularly, it is known that phosphors (YAG:Ce), obtained by adding Ce ions that function as the luminescence center to yttrium aluminum garnet, are excited by electron beams, ultraviolet rays, corpuscular radiation such as blue light, or electromagnetic irradiation, and emit visible yellow-green light. It also is known that the 1/10 decay time of the phosphors is a few ns or less, which is extremely short. Therefore, the phosphors are used widely in various light-emitting devices (for example, see Patent Documents 1, 2 and Non-Patent Document 1).

Typical examples of light-emitting devices that use such yttrium-aluminum-garnet phosphors include white LEDs combining blue light-emitting diodes (LEDs) and yellow phosphors, projectors using LEDs or semiconductor lasers (LDs) and phosphors, illumination light sources using white LEDs, LCDs with LED backlights, and sensors and intensifiers using phosphors.

Further, in plasma display panels with a 3D image display function (3D-PDP), if the decay time of phosphors to be used is long, an overlap between a left eye image and a right eye image becomes worse due to moving image crosstalk, which causes the left eye image and the right eye image displayed by fast switching to overlap each other, whereby satisfactory 3D images cannot be displayed. To cope with this, as green phosphors for PDP that displays 3D images, a technology that uses YAG:Ce with a significantly short decay time has been proposed (for example, see Patent Document 3).

### Prior Art Documents

### Patent Documents

Patent Document 1: JP 3503139
Patent Document 2: US Patent Publication 6,812,500
Patent Document 3: JP 2006-193712 A

### Non-Patent Document

Non-Patent Document 1: Phosphor Handbook, edited by Keikoutai Dougakkai, published by Ohmsha, Ltd., pp. 12, 237-238, 268-278, 332)

### Disclosure of Invention

### Problem to be Solved by the Invention

However, in the above-described conventional methods, since the luminance of YAG:Ce phosphors is low, it is difficult to configure high-efficiency light-emitting devices. Moreover, in the case of configuring white light-emitting devices that combine blue LEDs and YAG:Ce phosphors, although the reduction in particle diameter of YAG:Ce phosphors can reduce variation in the color temperature of emitted white light, it further reduces the luminance of the phosphors in the conventional technology This makes it difficult to achieve both the reduction in variation in the color temperature and high luminance.

The present invention has been achieved to solve the above-described conventional problems, and its object is to provide a high-efficiency light-emitting device, and a light-emitting device with high efficiency and small variation in the color temperature of emitted white light in the case of configuring, for example, a white light-emitting device that combines a blue LED and a phosphor layer.

### Means for Solving Problem

In order to solve the above-described problems, a light-emitting device of the present invention includes a phosphor layer that emits light having a predetermined wavelength, wherein the phosphor layer contains at least one selected from the group consisting of a phosphor represented by a general formula:

aYO_{3/2} • (3-a)CeO_{3/2} • bAlO_{3/2} • cGaO_{3/2} • fWO₃ (2.80 ≤ a ≤ 2.99, 3.00 ≤ b ≤ 5.00, 0 ≤ c ≤ 2.00, 0.003 ≤ f ≤ 0.020, where 4.00 ≤ b+c ≤ 5.00), and a phosphor represented by a general formula: aYO_{3/2} • (3-a)CeO_{3/2} • bAlO_{3/2} • cGaO_{3/2} • gK₂WO₄ (2.80 ≤ a ≤ 2.99, 3.00 ≤ b ≤ 5.00, 0 ≤ c ≤ 2.00, 0.003 ≤ g ≤ 0.015, where 4.00 ≤ b+c ≤ 5.00).

### Effect of the Invention

According to the present invention, it is possible to provide a high-efficiency light-emitting device. Further, in combination with a blue LED, it is possible to provide a white light-emitting device with high efficiency and reduced variation in the color temperature of emitted white light.

### Brief Description of Drawing

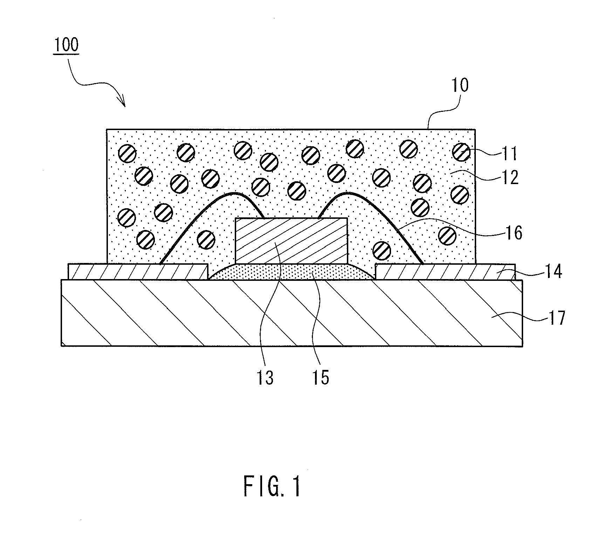

[FIG. 1] FIG. 1 is a cross-sectional schematic diagram showing an exemplary configuration of a light-emitting device.

### Description of the Invention

The light-emitting device disclosed in the present application includes a phosphor layer that emits light having a predetermined wavelength, wherein the phosphor layer contains at least one selected from the group consisting of a phosphor represented by a general formula: aYO_{3/2} • (3-a)CeO_{3/2} • bAlO_{3/2} • cGaO_{3/2} • fWO₃ (2.80 ≤ a ≤ 2.99, 3.00 ≤ b ≤ 5.00, 0 ≤ c ≤ 2.00, 0.003 ≤ f ≤ 0.020, where 4.00 ≤ b+c ≤ 5.00), and a phosphor represented by a general formula:

aYO_{3/2} • (3-a)CeO3/2 • bAlO_{3/2} • cGaO_{3/2} • gK₂WO₄ (2.80 ≤ a ≤ 2.99, 3.00 ≤ b ≤ 5.00, 0 ≤ c ≤ 2.00, 0.003 ≤ g ≤ 0.015, where 4.00 ≤ b+c ≤ 5.00).

With the above-described configuration, the light-emitting device disclosed in the present application can be a light-emitting device with high efficiency because the phosphors contained in the phosphor layer have short decay and high emission luminance. Further, by combining a blue LED and the phosphor layer, a white light-emitting device with high efficiency and reduced variation in the color temperature of emitted white light can be provided.

In the above-described light-emitting device, when the phosphor layer contains a phosphor represented by the general formula:

aYO_{3/2} • (3-a)CeO_{3/2} • bAlO_{3/2} • cGaO_{3/2} • fWO₃, a value f preferably is 0.005 ≤ f ≤ 0.010,

and when the phosphor layer contains a phosphor represented by the general formula:

aYO_{3/2} • (3-a)CeO_{3/2} • bAlO_{3/2} • cGaO_{3/2} • gK₂WO₄, a value g preferably is 0.005 ≤ g ≤ 0.010.

With this configuration, the luminance of YAG phosphors to be used can be increased further, which makes it possible to obtain a high-efficiency light-emitting device.

Moreover, it is preferable that the light-emitting device further includes a semiconductor light-emitting element that emits light having a peak wavelength within a wavelength range of 380 to 460 nm, wherein the phosphor layer absorbs part of light emitted by the semiconductor light-emitting element, and emits light having a peak wavelength within a wavelength range that is longer than the wavelength of the absorbed light. With this configuration, by using blue light emitted by the semiconductor light-emitting element and light of yellow-green converted by the phosphor layer, it is possible to realize an LED radiating white light.

In this case, the semiconductor light-emitting element may have a light-emitting layer composed of a gallium nitride compound semiconductor.

Hereinafter, as an embodiment of the light-emitting device of the present invention, a light-emitting device that includes a phosphor layer combined with a blue LED element will be exemplified and described in detail.

### <Composition of phosphors>

A first phosphor to be contained in the phosphor layer of the light-emitting device disclosed in the present application is represented by a general formula:

aYO_{3/2} • (3-a)CeO_{3/2} • bAlO_{3/2} • cGaO_{3/2} • fWO3 (2.80 ≤ a ≤ 2.99, 3.00 ≤ b ≤ 5.00, 0 ≤ c ≤ 2.00,

0.003 ≤ f ≤ 0.020, where 4.00 ≤ b+c ≤ 5.00). Note that a preferable range of f is 0.005 ≤ f ≤ 0.010 in view of the luminance achieved.

Further, a second phosphor to be contained in the phosphor layer of the light-emitting device disclosed in the present application is represented by a general formula: aYO_{3/2} • (3-a)CeO_{3/2} • bAlO_{3/2} • cGaO_{3/2} • gK₂WO₄ (2.80 ≤ a ≤ 2.99, 3.00 ≤ b ≤ 5.00, 0 ≤ c ≤ 2.00, 0.003 ≤ g ≤ 0.015, where 4.00 ≤ b+c ≤ 5.00). In this case, a preferable range of g is 0.005 ≤ g ≤ 0.010 in view of the luminance achieved.

### <Production method of phosphors>

Hereinafter, a method of producing phosphors to be contained in the phosphor layer of the light-emitting device disclosed in the above-described present application will be described. Note that the following production method is merely an example, and the method of producing phosphors to be contained in the phosphor layer of the light-emitting device disclosed in the present application is not limited thereto.

As materials of the phosphors, it is possible to use compounds that become oxides by sintering, such as hydroxides, carbonates and nitrates of high purity (purity: 99% or more), or oxides of high purity (purity: 99% or more).

Further, in order to accelerate the reaction, it is preferable to add a small amount of fluoride (aluminum fluoride, etc) or chloride (zinc chloride, etc).

Phosphors are produced by mixing and sintering the above-described materials. A method of mixing the materials may be wet mixing in a solution or dry mixing of dry powder, and can use a ball mill, a medium agitation mill, a planetary mill, a vibration mill, a jet mill, a V-type mixer, an agitator, etc., which generally are used industrially.

Sintering of mixed power is first performed at a temperature ranging from 1100°C to 1600°C for about 1 to 50 hours in the air.

Further, sintering of mixed power is performed at a temperature ranging from 1200°C to 1400°C for about 1 to 50 hours in an atmosphere of a given oxygen partial pressure formed by nitrogen gas or carbon dioxide gas containing 0 to 50% by volume of nitrogen, or mixed gas such as nitrogen gas containing 0 to 5% by volume of hydrogen.

A furnace that is used generally for industrial purposes can be used for sintering. A continuous electric furnace such as a pusher furnace or a batch-type electric furnace, or a gas furnace can be used.

The obtained phosphor powder is crushed again using a ball mill or a jet mill, and washed or classified if required. Thus, a particle size distribution and flowability of the phosphor powder can be adjusted.

### <Configuration of light-emitting device>

The configuration of the light-emitting device according to the present embodiment will be described with reference to a drawing.

FIG. 1 is a cross-sectional schematic diagram showing an exemplary light-emitting device according to the present embodiment.

A light-emitting device 100 includes a semiconductor light-emitting element 13 and a phosphor layer 10 that is formed to cover the semiconductor light-emitting element 13. The phosphor layer 10 contains phosphors 11 dispersed in a resin 12.

The semiconductor light-emitting element 13 is fixed to a substrate 17 via a die bond 15. Further, the semiconductor light-emitting element 13 is connected electrically to an electrode 14 via a bonding wire 16. By applying a predetermined voltage to the electrode 14, the semiconductor light-emitting element 13 emits light in a blue region having a peak wavelength within a wavelength range of 380 to 460 nm.

The phosphors 11 of the phosphor layer 10 absorb part of the light emitted by the semiconductor light-emitting element 13, and emit light in a yellow region having a peak wavelength within a wavelength range that is longer than the wavelength of the absorbed light. Since the resin 12 constituting the phosphor layer 10 transmits the light in the blue region emitted by the semiconductor light-emitting element 13, the light-emitting device 100 emits white light by mixing colors of blue light that has not be adsorbed by the phosphors 11 and yellow light emitted by the phosphors 11.

Incidentally, if the mixing ratio between the blue light that has not been adsorbed by the phosphors 11 and the yellow light emitted by the phosphors 11 changes, the color temperature of white light changes. Hence, the phosphors 11 need to be dispersed in the resin 12 homogeneously, and the particle diameter of the phosphors 11 preferably is small.

### Examples

Hereinafter, the light-emitting device disclosed in the present application will be described in detail with reference to specific examples and comparative examples. Note that the following examples do not limit the light-emitting device disclosed in the present application.

### <Production of first phosphor samples>

Y₂O₃, Al₂O₃, Ga₂O₃, CeO₂ and WO₃ were used as starting materials. These materials were weighed so as to obtain predetermined compositions, and subjected to wet mixing in pure water using a ball mill. The obtained mixtures were each dried, and then sintered at a temperature ranging from 1,100°C to 1,600°C for four hours in the air. Further, the mixtures were sintered at 1,200°C to 1,400°C for four hours in carbon dioxide gas containing 0 to 50% by volume of nitrogen, whereby phosphors were obtained.

Further, the obtained phosphor powders were crushed again using the ball mill so as to adjust a particle size distribution.

### <Luminance measurement>

The phosphor samples corresponding to examples and comparative examples were subjected to luminance measurement under conditions below.
(1) Irradiation of the respective phosphor samples with vacuum ultraviolet light having a wavelength of 146 nm in vacuum, and measurement of emitted light in the green region
(2) Irradiation of the respective phosphor samples with blue light having a wavelength of 450 nm in the air, and measurement of emitted light in the yellow region

Table 1 shows composition ratios, average particle diameters and luminances (Y) of the produced phosphors. Here, the luminance (Y) represents luminance Y in an XYZ color specification system of Commission Internationale de l'Eclairage, which is a relative value in the case of setting the value Y to be 100 in a phosphor created as Sample No. 1 where a=2.80, b=5.00, c=0, and f=0. In Table 1, samples with a symbol "*" attached to Sample Nos. are phosphors corresponding to the comparative examples out of the range of the composition of the phosphor disclosed in the present application.

**[Table 1]**

| Sample No. | a | b | c | f | Average particle diameter (µm) | Relative value of luminance (%) | |
|---|---|---|---|---|---|---|---|
| | | | | | | 146 nm excitation | 450 nm excitation |
| *1 | 2.80 | 5.00 | 0 | 0 | 10 | 100 | 100 |
| *2 | 2.80 | 5.00 | 0 | 0 | 5 | 92 | 85 |
| *3 | 2.80 | 5.00 | 0 | 0 | 2 | 87 | 76 |
| *4 | 2.70 | 5.20 | 0 | 0 | 10 | 78 | 83 |
| *5 | 2.70 | 5.20 | 0 | 0 | 5 | 72 | 74 |
| *6 | 2.70 | 5.20 | 0 | 0 | 2 | 69 | 66 |
| *7 | 2.80 | 0.50 | 4.00 | 0 | 10 | 43 | 52 |
| *8 | 2.80 | 0.50 | 4.00 | 0 | 5 | 38 | 43 |
| *9 | 2.80 | 0.50 | 4.00 | 0 | 2 | 36 | 34 |
| *10 | 2.80 | 5.00 | 0 | 0.050 | 10 | 89 | 84 |
| *11 | 2.80 | 5.00 | 0 | 0.050 | 5 | 86 | 80 |
| *12 | 2.80 | 5.00 | 0 | 0.050 | 2 | 82 | 78 |
| 13 | 2.80 | 5.00 | 0 | 0.020 | 10 | 112 | 117 |
| 14 | 2.80 | 5.00 | 0 | 0.020 | 5 | 108 | 109 |
| 15 | 2.80 | 5.00 | 0 | 0.020 | 2 | 103 | 103 |
| 16 | 2.99 | 5.00 | 0 | 0.003 | 10 | 118 | 106 |
| 17 | 2.99 | 5.00 | 0 | 0.003 | 5 | 112 | 100 |
| 18 | 2.99 | 5.00 | 0 | 0.003 | 2 | 103 | 93 |
| 19 | 2.97 | 3.00 | 2.00 | 0.010 | 10 | 142 | 125 |
| 20 | 2.97 | 3.00 | 2.00 | 0.010 | 5 | 139 | 120 |
| 21 | 2.97 | 3.00 | 2.00 | 0.010 | 2 | 136 | 112 |
| 22 | 2.97 | 4.00 | 1.00 | 0.005 | 10 | 148 | 133 |
| 23 | 2.97 | 4.00 | 1.00 | 0.005 | 5 | 141 | 126 |
| 24 | 2.97 | 4.00 | 1.00 | 0.005 | 2 | 137 | 120 |
| 25 | 2.98 | 3.90 | 1.10 | 0.005 | 10 | 155 | 125 |
| 26 | 2.98 | 3.90 | 1.10 | 0.005 | 5 | 149 | 115 |
| 27 | 2.98 | 3.90 | 1.10 | 0.005 | 2 | 140 | 109 |

As is apparent from Table 1, regarding the phosphors (Sample Nos. 13-27) whose composition ratios are within the composition range disclosed in the present application, i.e., the phosphors satisfying the condition of (2.80 ≤ a ≤ 2.99, 3.00 ≤ b ≤ 5.00, 0 ≤ c ≤ 2.00, 0.003 ≤ f ≤ 0.020, where 4.00 ≤ b+c ≤ 5.00), the luminance obtained by excitation using vacuum ultraviolet light and the luminance obtained by excitation using blue light are both high. Among them, the phosphors indicated as Sample Nos. 19 to 27 in Table 1 whose composition ratios are within the range of 0.005 ≤ f ≤ 0.010 have particularly high luminance. Further, a decrease in luminance due to the reduction in particle diameter of these phosphors is quite small.

### <Production of second phosphor samples>

Y₂O₃, Al₂O₃, Ga₂O₃, CeO₂ and K₂WO₄ were used as starting materials. These materials were weighed so as to obtain predetermined compositions, and subjected to wet mixing in pure water using a ball mill. The obtained mixtures were each dried, and then sintered at a temperature ranging from 1,100°C to 1,600°C for four hours in the air. Further, the mixtures were sintered at a temperature ranging from 1,200°C to 1,400°C for four hours in nitrogen gas or nitrogen gas containing 0 to 5% by volume of hydrogen, whereby phosphors were obtained.

The obtained phosphor powders were crushed again using the ball mill to adjust a particle size distribution.

Table 2 shows composition ratios, average particle diameters of the produced phosphors, and luminances (Y) of the samples measured by the above-described method. Also in Table 2, Y is a relative value in the case of setting the value Y to be 100 in a phosphor created as Sample No. 1 in Table 1. In Table 2, samples with a symbol "*" attached to Sample Nos. are phosphors corresponding to the comparative examples out of the range of the composition of the phosphor disclosed in the present application.

**[Table 2]**

| Sample No. | a | b | c | g | Average particle diameter (µm) | Relative value of luminance (%) | |
|---|---|---|---|---|---|---|---|
| | | | | | | 146 nm excitation | 450 nm excitation |
| *28 | 2.80 | 5.00 | 0 | 0.040 | 10 | 76 | 74 |
| *29 | 2.80 | 5.00 | 0 | 0.040 | 5 | 74 | 70 |
| *30 | 2.80 | 5.00 | 0 | 0.040 | 2 | 70 | 66 |
| 31 | 2.80 | 5.00 | 0 | 0.015 | 10 | 118 | 120 |
| 32 | 2.80 | 5.00 | 0 | 0.015 | 5 | 114 | 113 |
| 33 | 2.80 | 5.00 | 0 | 0.015 | 2 | 108 | 108 |
| 34 | 2.99 | 5.00 | 0 | 0.003 | 10 | 122 | 111 |
| 35 | 2.99 | 5.00 | 0 | 0.003 | 5 | 114 | 104 |
| 36 | 2.99 | 5.00 | 0 | 0.003 | 2 | 106 | 96 |
| 37 | 2.97 | 3.00 | 2.00 | 0.010 | 10 | 148 | 130 |
| 38 | 2.97 | 3.00 | 2.00 | 0.010 | 5 | 142 | 124 |
| 39 | 2.97 | 3.00 | 2.00 | 0.010 | 2 | 138 | 115 |
| 40 | 2.97 | 4.00 | 1.00 | 0.005 | 10 | 152 | 132 |
| 41 | 2.97 | 4.00 | 1.00 | 0.005 | 5 | 148 | 123 |
| 42 | 2.97 | 4.00 | 1.00 | 0.005 | 2 | 140 | 120 |
| 43 | 2.98 | 3.90 | 1.10 | 0.005 | 10 | 159 | 132 |
| 44 | 2.98 | 3.90 | 1.10 | 0.005 | 5 | 150 | 124 |
| 45 | 2.98 | 3.90 | 1.10 | 0.005 | 2 | 143 | 118 |

As is apparent from Table 2, regarding the phosphors (Sample Nos. 31-45) whose composition ratios are within the composition range disclosed in the present application, i.e., the phosphors satisfying the condition of (2.80 ≤ a ≤ 2.99, 3.00 ≤ b ≤ 5.00, 0 ≤ c ≤ 2.00, 0.003 ≤ g ≤ 0.015, where 4.00 ≤ b+c ≤ 5.00), the luminance obtained by excitation using vacuum ultraviolet light and the luminance obtained by excitation using blue light are both high. Among them, the phosphors indicated as Sample Nos. 37 to 45 in Table 2 whose composition ratios are within the range of 0.005 ≤ g ≤ 0.010 have particularly high luminance. Further, a decrease in luminance due to the reduction in particle diameter of these phosphors is quite small.

As can be seen from the measurement results above, since the phosphors disclosed in the present application have high luminance, it is possible to configure a high-efficiency light-emitting device when they are used as phosphors for a light-emitting device with a phosphor layer. Specifically, in a light-emitting device with a phosphor layer in which conventional YAG:Ce phosphors are used, a high-efficiency light-emitting device may be configured by replacing the conventional phosphors with the above-described first phosphors or the second phosphors and following known methods as to components other than the phosphor layer.

Examples of the light-emitting device include a white light-emitting device combining a blue LED and yellow phosphors, a light-emitting device as a light source of a projector using an LED or LD and phosphors, a backlight of an illumination light source or an LCD with LED backlight, a sensor and an intensifier using phosphors, a 3D-PDP, etc.

### <Production of light-emitting device>

With use of a triple roll mixer, dimethyl silicone resin was mixed with phosphors prepared in the same manner as those of Sample Nos. 1 to 3 (comparative examples) shown in the above Table 1, those of Sample Nos. 22 to 24 (examples) shown also in Table 1, those of Sample Nos. 28 to 30 (comparative examples) shown in Table 2, and those of Sample Nos. 31 to 33 and 40 to 42 (examples) shown in Table 2, whereby mixtures were obtained.

The obtained mixtures were filled in a mold, defoamed by vacuum defoaming, adhered to a gallium nitride semiconductor light-emitting element of 600 µm square (peak wavelength: 442 nm) wired on a substrate, and temporarily heat-cured at 150°C for 10 minutes. After removing the mold, the resultants were heat-cured at 150°C for 4 hours. Thus, light-emitting devices as shown in FIG. 1 were obtained. Incidentally, the weight ratio of the phosphors to the resin in the mixture was adjusted in the vicinity of 30% by weight so that the color temperature of emitted white light is in the vicinity of 6500 K.

The thus produced light-emitting devices were numbered consecutively from Sample Nos. 46 to 60 according to the numbers of the phosphor samples used, and caused to emit light for measurement of respective light-emission efficiencies.

The light-emission efficiency was measured by applying a current of 500 mA with a pulse width of 30 ms to the above-described light-emitting devices of Sample Nos. 46 to 60, and measuring emitted white light by a total luminous flux measurement system (HM φ 300 mm).

Table 3 shows Sample Nos. of the phosphors used for the produced light-emitting devices and light-emission efficiencies of the respective light-emitting device samples obtained by the above-described measurement method. Incidentally, the light-emission efficiency is a relative value in the case of setting a value of the light-emission efficiency in the light-emitting device of Sample No. 46 to be 100. Further, in Table 3, samples with a symbol "*" attached to Sample Nos. are light-emitting devices as comparative examples that use phosphors corresponding to the comparative examples out of the range of the composition of the phosphors disclosed in the present application.

**[Table 3]**

| Sample No. | Phosphor used | Relative value of light-emission efficiency (%) |
|---|---|---|
| *46 | Sample No. 1 | 100 |
| *47 | Sample No. 2 | 78 |
| *48 | Sample No. 3 | 63 |
| 49 | Sample No. 22 | 116 |
| 50 | Sample No. 23 | 112 |
| 51 | Sample No. 24 | 107 |
| *52 | Sample No. 28 | 85 |
| *53 | Sample No. 29 | 80 |
| *54 | Sample No. 30 | 72 |
| 55 | Sample No. 31 | 111 |
| 56 | Sample No. 32 | 106 |
| 57 | Sample No. 33 | 103 |
| 58 | Sample No. 40 | 122 |
| 59 | Sample No. 41 | 118 |
| 60 | Sample No. 42 | 112 |

As is apparent from Table 3, the light-emitting devices of Sample Nos. 49 to 51 and Sample Nos. 55 to 60 corresponding to examples disclosed in the present application all exhibit high light-emission efficiencies. Further, high light-emission efficiency can be achieved even when the diameter of the phosphors is reduced. Thus, a light-emitting device with high efficiency and less variation in the color temperature of emitted white light can be obtained.

Actually, ten each of light-emitting devices identical to those of Sample Nos. 58 and 60 were prepared, and respective variations in the color temperature were evaluated. Consequently, it was confirmed that the reduction in the particle diameter of phosphors suppresses a variation width of the color temperature (i.e., a value obtained by subtracting minimum color temperature from maximum color temperature) to one third or less of the case of light-emitting elements using conventional YAG:Ce phosphors.

In the light-emitting device disclosed in the above-described present application, the phosphor layer contains at least one selected from the group consisting of a phosphor represented by a general formula:

aYO_{3/2} • (3-a)CeO_{3/2} • bAlO_{3/2} • cGaO_{3/2} • fWO₃ (2.80 ≤ a ≤ 2.99, 3.00 ≤ b ≤ 5.00, 0 ≤ c ≤ 2.00,

0.003 ≤ f ≤ 0.020, where 4.00 ≤ b+c ≤ 5.00), and a phosphor represented by a general formula: aYO_{3/2} • (3-a)CeO_{3/2} • bAlO_{3/2} • cGaO_{3/2} • gK₂WO₄ (2.80 ≤ a ≤ 2.99, 3.00 ≤ b ≤ 5.00, 0 ≤ c ≤ 2.00, 0.003 ≤ g ≤ 0.015, where 4.00 ≤ b+c ≤ 5.00). Thus, it is possible to provide a high-efficiency light-emitting device. Further, in combination with a blue LED, it is possible to provide a white light-emitting device with high efficiency and reduced variation in the color temperature of emitted white light.

As an example of the light-emitting device disclosed in the present application, the above embodiment describes the light-emitting device that uses a gallium nitride semiconductor light-emitting element having a peak wavelength of 442 nm as a blue LED, and that emits white light by a phosphor layer.

However, the light-emitting device disclosed in the present application is not limited thereto, and the blue LED used together with the phosphor layer as the light-emitting device that emits white light may be one that has an emission wavelength ranging from 380 to 460 nm. Further, the semiconductor light-emitting element is not limited to gallium nitride. Needless to say, the ratio and emission color of the phosphors contained in the phosphor layer as well as the tone of color of the resin constituting the phosphor layer should be selected appropriately in accordance with the color temperature of desired white light and the wavelength of light radiated by the blue LED as the semiconductor light-emitting element.

Further, as a phosphor layer, the above-described embodiment exemplifies the phosphor layer that uses either one of the first phosphor represented by the general formula: aYO_{3/2} • (3-a)CeO_{3/2} • bAlO_{3/2} • cGaO_{3/2} • fW03 (2.80 ≤ a ≤ 2.99, 3.00 ≤ b ≤ 5.00, 0 ≤ c ≤ 2.00, 0.003 ≤ f ≤ 0.020, where 4.00 ≤ b+c ≤ 5.00), and the second phosphor represented by the general formula: aYO_{3/2} • (3-a)CeO_{3/2} • bAlO_{3/2} • cGaO_{3/2} • gK₂WO₄ (2.80 ≤ a ≤ 2.99, 3.00 ≤ b ≤ 5.00, 0 ≤ c ≤ 2.00, 0.003 ≤ g ≤ 0.015, where 4.00 ≤ b+c ≤ 5.00). However, the light-emitting device disclosed in the present application is not limited thereto. Particularly, in the case of adjusting the emission color of phosphors contained in the phosphor layer, the phosphor layer may contain both of the above-described first phosphor and the second phosphor, and also may contain phosphors other than the first phosphor and the second phosphor.

Further, the light-emitting device using the phosphor layer in combination with the semiconductor light-emitting element is not limited to the light-emitting device that emits white light as in the above-described embodiment, and may be a light-emitting device that emits light of another wavelength by being combined with a semiconductor light-emitting element of another color, for example. In this case, as a semiconductor light-emitting element, an LD may be used other than an LED.

Further, examples of the light-emitting device disclosed in the present application may include various types of light-emitting devices provided with a phosphor layer containing at least either one of the above-described first phosphor and the second phosphor, such as a projector and a white LED illumination light source and the like using phosphors and a light-emitting diode (LED) or semiconductor laser (LD), and a sensor, an intensifier and a plasma display panel (PDP) using phosphors.

Incidentally, for example, in the case of configuring a PDP as a light-emitting device, the PDP is not configured to transmit light emitted from a blue LED as in the light-emitting device shown in the above-described embodiment, but configured so that phosphors are caused to emit light by ultraviolet rays excited by discharge in a panel. Because of this, the phosphor layer does not have a configuration in which phosphor particles are dispersed in the resin as illustrated in FIG. 1, but have a configuration in which phosphor particles are arranged more densely via a binder. As such, needless to say, the phosphor layer of the light-emitting device disclosed in the present application will have a configuration that meets the principle of light emission in the light-emitting device.

### Industrial Applicability

Since the light-emitting device of the present invention is highly efficient, it is useful in various applications. Specifically, it is applicable for use in a white light-emitting device combining a blue LED and yellow phosphors, a projector using an LED or LD and phosphors, and an illumination light source using a white light-emitting device, an LCD with LED backlight, and a sensor, an intensifier, a 3D-PDP and the like using phosphors. Further, in the case of configuring a white light-emitting device combining a blue LED and YAG:Ce phosphors, it is possible to provide a light-emitting device with high efficiency and small variation in the color temperature of emitted white light.

## Claims

1. A light-emitting device comprising a phosphor layer that emits light having a predetermined wavelength,
wherein the phosphor layer contains at least one selected from the group consisting of a phosphor represented by a general formula:
aYO_{3/2} • (3-a)CeO_{3/2} • bAlO_{3/2} • cGaO_{3/2} • fW03 (2.80 ≤ a ≤ 2.99, 3.00 ≤ b ≤ 5.00, 0 ≤ c ≤ 2.00,
0.003 ≤ f ≤ 0.020, where 4.00 ≤ b+c ≤ 5.00), and a phosphor represented by a general formula: aYO_{3/2} • (3-a)CeO_{3/2} • bAlO_{3/2} • cGaO_{3/2} • gK₂WO₄ (2.80 ≤ a ≤ 2.99, 3.00 ≤ b ≤ 5.00, 0 ≤ c ≤ 2.00, 0.003 ≤ g ≤ 0.015, where 4.00 ≤ b+c ≤ 5.00).

2. The light-emitting device according to claim 1, wherein the phosphor layer contains a phosphor represented by the general formula:
aYO_{3/2} • (3-a)CeO_{3/2} • bAlO_{3/2} • cGaO_{3/2} · fW03, where 0.005 ≤ f ≤ 0.010.

3. The light-emitting device according to claim 1, wherein the phosphor layer contains a phosphor represented by the general formula:
aYO_{3/2} • (3-a)CeO_{3/2} • bAlO_{3/2} • cGaO_{3/2} • gK₂WO₄, where 0.005 ≤ g ≤ 0.010.

4. The light-emitting device according to any one of claims 1 to 3, further comprising a semiconductor light-emitting element that emits light having a peak wavelength within a wavelength range of 380 to 460 nm,
wherein the phosphor layer absorbs part of light emitted by the semiconductor light-emitting element, and emits light having a peak wavelength within a wavelength range that is longer than the wavelength of the absorbed light.

5. The light-emitting device according to claim 4, wherein the semiconductor light-emitting element has a light-emitting layer composed of a gallium nitride compound semiconductor.
